# EUROPEAN PATENT APPLICATION

(11) **EP 2 509 118 A1**
(43) Date of publication of application: **10.10.2012**
(21) Application number: 11161202.4
(22) Date of filing: 05.04.2011
(51) Int. Cl.: H01L 31/18, H01L 31/0224, H01L 31/0236

(54) **Method for forming tco films and thin film stack**

(71) Applicant: Applied Materials, Inc., Santa Clara, CA 95024 (US)
(72) Inventor: Schmidt, Ursula Ingeborg, 63755, Alzenau (DE); Sommer, Elisabeth, 63755, Alzenau (DE); Vermeir, Inge, 91077, Neunkirchen (DE); Kress, Markus, 63165, Mühlheim (DE); Kuhr, Niels, 63739, Aschaffenburg (DE); Obermeyer, Philipp, 33602 Bielefeld (DE); Severin, Daniel, 63477, Maintal (DE); Supritz, Anton, 93326, Offenstetten (DE)
(74) Representative: Zimmermann & Partner

(57) **Abstract**

A method for controlling surface morphology of a transparent conductive oxide film (TCO, 104) is provided. A substrate (101) is provided as a basis for forming a solar cell. Onto the substrate (101), a seed layer (103) is deposited. Then, the method includes depositing the transparent conductive oxide film (TCO, 104) above the seed layer 103. The seed layer 103 is adapted to control the surface morphology of the transparent conductive oxide film (104). The surface of the transparent conductive oxide film (104) is etched in order to provide a front contact of the solar cell.

## Description

### TECHNICAL FIELD OF THE INVENTION

Embodiments of the present invention relate to a deposition method for forming thin films onto substrates, and in particular relates to a method for forming transparent conductive oxide films adapted for use within solar cells. Furthermore, embodiments of the present invention relate to a thin film stack including at least one transparent conductive oxide film.

### BACKGROUND OF THE INVENTION

The demand for electrical energy and the development of clean energy sources is continuously increasing. In order to meet the future demand for energy, renewable energy sources are being explored. Solar energy may be used as an energy source for providing electrical energy generated by solar cells. Devices for an efficient conversion of solar energy into electrical energy are manifold. A variety of devices are based on thin-film solar cells which can be produced by depositing appropriate thin films onto substrates such as wafers. It is a current trend to produce large-area solar cells having high efficiency. Thin-film solar cells are generally formed from numerous types of films, or layers, combined in many different ways. Characteristics of the different films include degree of crystallinity, dopant type, dopant concentration, film refractive index, film extinction coefficient, film transparency, film absorption, and conductivity. Typically, many of these films can be formed by use of a sputter deposition process.

In order to produce solar cells based on thin film structures, a deposition system may be provided which is capable of depositing the variety of functional layers used within the solar cells. Besides large deposition area, good layer uniformity with respect to composition and layer thickness, low manufacturing costs for producing the thin-film devices, an efficient use of deposition material, and surface morphology of the deposited layers are further issues.

### SUMMARY OF THE INVENTION

In light of the above, a method for controlling the surface morphology of a transparent conductive oxide film in accordance with independent claim 1 and a layer stack for a thin-film solar cell having a front contact in accordance with independent claim 9 is provided.

According to one embodiment, a method for controlling surface morphology of a transparent conductive oxide film is provided, the method including providing a transparent substrate surface; depositing a seed layer above the substrate surface, wherein the seed layer includes a material selected from the group consisting of Al, Ti, Zn, Si, and any combination thereof and has a thickness of 10 nm or less; depositing the transparent conductive oxide film above the seed layer, wherein the seed layer is adapted to control the surface morphology of the transparent conductive oxide film; and etching the surface of the transparent conductive oxide film.

According to a further embodiment, a layer stack for a thin film solar cell having a front contact is provided, the layer stack including a transparent substrate, a seed layer above the substrate surface adapted for controlling a surface morphology of a subsequent layer surface wherein the seed layer includes a material selected from the group consisting of Al, Ti, Zn, Si, and any combination thereof and has a thickness of 10 nm or less, and a conductive oxide film above the seed layer, wherein the conductive oxide film has an etched surface, and is adapted to form the front contact.

### BRIEF DESCRIPTION OF THE DRAWINGS

So that the manner in which the above recited features of the present invention can be understood in detail, a more particular description of the invention, briefly summarized above, may be had by reference to the embodiments. The accompanying drawings relate to embodiments of the invention and are described in the following:
- Figure 1: is a schematic view of a sputter deposition system having a sputtering target adapted for ejecting deposition material which is deposited onto a substrate;
- Figure 2: is a side-sectional view of a thin-film layer stack onto the substrate;
- Figure 3: is another side-sectional view of a thin-film layer stack similar to the thin-film layer stack shown in Fig. 2, with a buffer layer being deposited directly onto the substrate; and
- Figure 4: is a flowchart illustrating a method for controlling surface morphology of a transparent conductive oxide film.

### DETAILED DESCRIPTION OF THE EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Embodiments described herein refer inter alia to a method for controlling surface morphology of a transparent conductive oxide film (TCO film), which may be used for manufacturing solar cells or solar modules. For solar cells, a transparent substrate, such as a glass substrate, may be provided as a basis which is then coated by a seed layer deposited above the substrate surface. Then, the transparent conductive oxide film is deposited above the seed layer, wherein the seed layer is adapted to control a surface morphology of the transparent conductive oxide film. After depositing the transparent conductive oxide film above the seed layer, the surface of the transparent conductive oxide film may be etched in order to adjust the surface morphology (surface texture) of the transparent conductive oxide film.

Using the method for controlling surface morphology of the transparent conductive oxide film, a layer stack for a thin-film solar cell may be produced. The transparent conductive oxide film, which is deposited above the seed layer, may have an etched surface which is adapted to form the front contact.

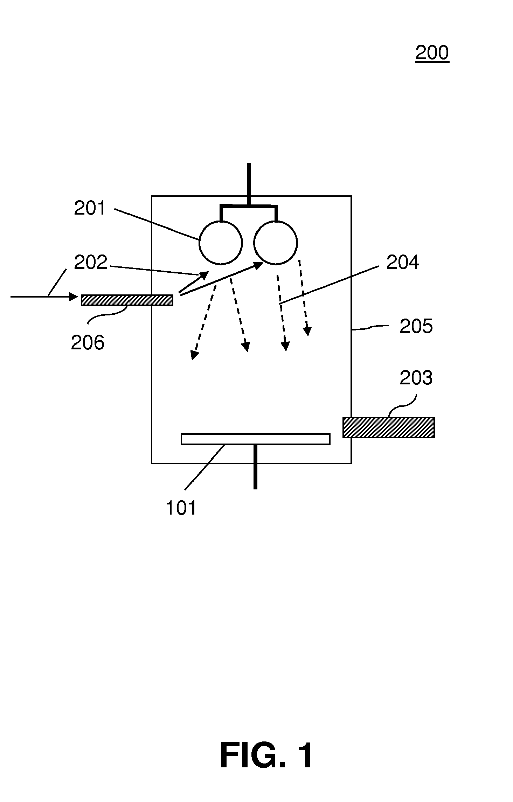

In order to obtain high deposition rates, a sputter deposition system such as a DC sputtering apparatus, which is exemplarily shown in Fig. 1, may be provided. Sputtering is a process in which atoms are ejected from a solid target material due to bombardment of the target by energetic particles. The process of coating a substrate as a material at the scraping refers typically to thin-film applications. Fig. 1 depicts a sputter deposition system 200 which includes a sputtering reactor 205. According to the schematic set-up shown in Fig. 1, within the sputtering reactor 205, a sputtering target 201 is provided which delivers deposition material for depositing thin films onto a substrate 101, which is located opposite to the sputtering target 201 and inside the sputtering reactor 205. The substrate 101 may be arranged with one or more heaters 207 adapted for controlling substrate the temperature during the deposition process.

A vacuum pump 203 is connected to the sputtering reactor 205 in order to provide an appropriate internal pressure in the sputtering reactor 205, the pressure being appropriate for the desired sputter deposition process. Additionally, the sputtering reactor 205 includes a sputtering gas inlet 206 adapted for introducing sputtering gas 202 into the sputtering reactor 205. The sputtering gas 202 is capable of sputtering deposition material 204 from the sputtering target 201. The deposition material 204 is then deposited onto the substrate 101 and forms the respective thin film onto the substrate 101.

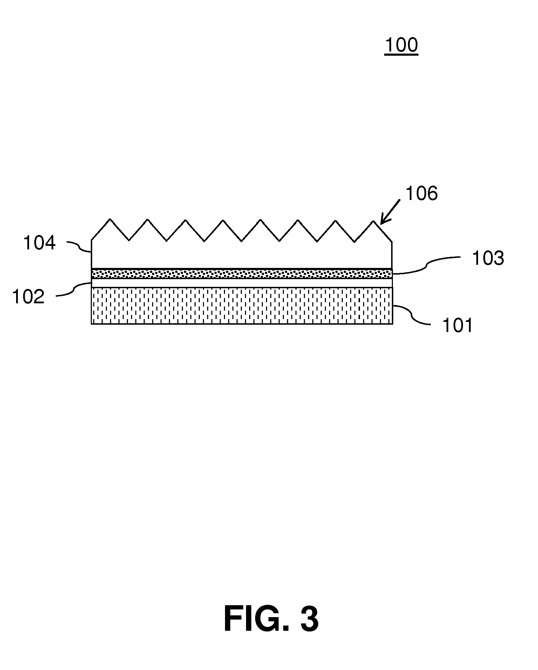

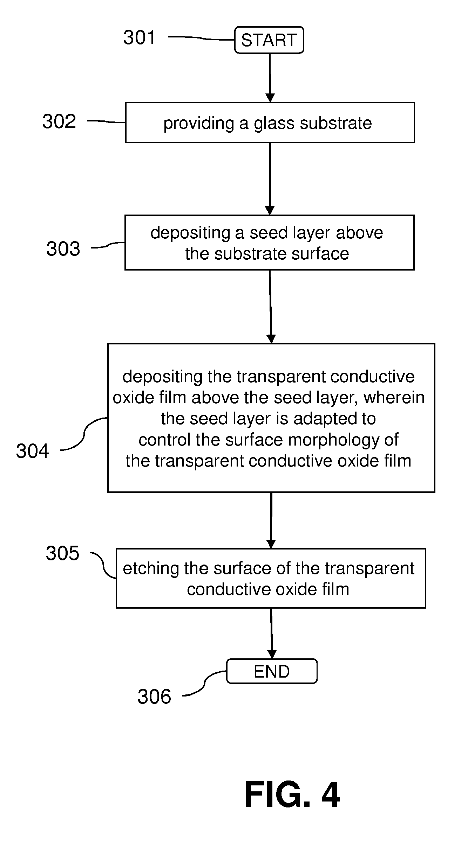

The sputtering process may be provided as a DC sputtering process in order to obtain high deposition rates. Before depositing the transparent conductive oxide film above the substrate surface, a seed layer is deposited which may influence the surface morphology of the transparent conductive oxide film, as will be described herein below with respect to Figs. 3 and 4. Thereby, nucleation of the TCO layer can be influenced to provide for improved texturing and desired electrical and optical properties of the TCO layer. Structuring or texturing of the transparent conductive oxide film in order to influence surface morphology of the transparent conductive oxide film may result in improved light-scattering properties which in turn may increase solar cell efficiency. According to yet further embodiments, the TCO layer can be wet-chemically etched, for example in diluted hydrochloric acid, or other suitable etchants. For example, the layer stack can be etched in diluted acid in order to roughen the ZnO surface by wet etching. According to yet further implementations, the etching process can be an isotropic or typically an anisotropic etching process. Thereby, as described above, the etching process is of importance for the surface texture, which is used to scatter the light, particularly the long wavelength light. Thereby, trapping of incident light which is converted into electrical energy using the solar cell, may be increased. In order to obtain these types of textured TCO films, a post-deposition etching step may be applied. Such texturing of layers or films can, for example, improve light trapping. In light thereof, incident radiation can be scattered within the layers. Generally, the scattering increases the path length available for interaction of the photons for the desired light absorption. Further, the photons are diffracted at the boundaries of the layers such that the photons might even remain in one layer by total internal reflection upon diffraction at the textured TCO layer. Thereby, the path length within the desired layer in which photons should be absorbed for light conversion is increased. This generally improves the efficiency of the layer stack for the solar cell.

High-haze ZnO films, which are deposited by RF sputter deposition, can be provided on small scales and to laboratory standards. However, the RF technique suffers from a very low deposition rate and the difficulty to scale up the process to large areas. Thereby, it is desirable that the TCO layer has a high surface roughness with large lateral feature sizes in order to capture as much of the incoming sun light as possible in the Si absorber of the solar cell.

In this way, solar cells having a low electrical resistivity and high optical transmittance combined with good light trapping properties may be provided. This type of photon trapping is an issue during manufacturing of thin-film solar cells. Various light-trapping techniques can be employed. A layer stack in accordance with embodiments described herein includes a textured surface of the transparent conductive oxide film which provides a good trapping of incident light.

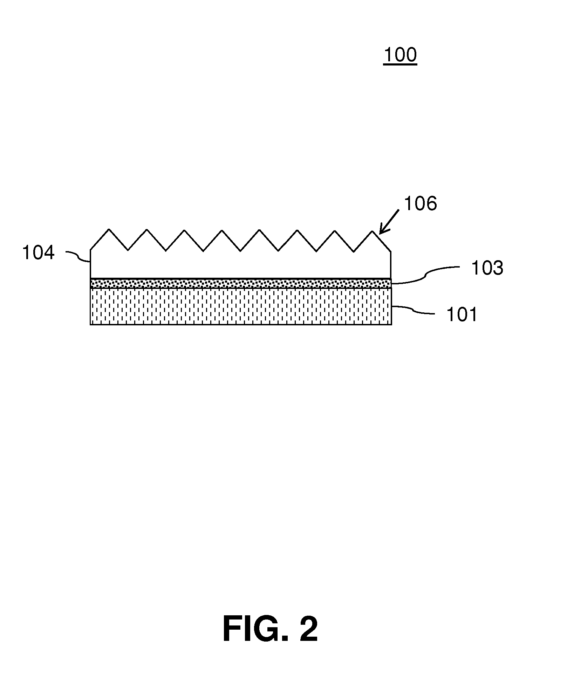

During sputter deposition of the thin films within the sputtering reactor 205 shown in Fig. 1, temperature and pressure may be varied. The transparent conductive oxide film is then used as a front contact, as will be described herein below with respect to Figs. 2 and 3. The combination of the seed layer and high-rate deposition using a DC-sputtering process are the basis for providing solar cells of high efficiency.

Fig. 2 is a side sectional view of a layer stack 100 adapted for forming a solar cell. The basis of the solar cell is a substrate 101 which may be provided as a glass pane. Using the sputter deposition system 200 shown in Fig. 1, for example, a seed layer 103 may be deposited onto the surface of the substrate 101. The seed layer 103 may be adapted to provide a nucleation of deposition material 204 deposited onto at least portions of the seed layer 103 as will be explained in detail herein below.

According to a typical embodiment, which can be combined with other embodiments described herein, the seed layer 103 may be a layer having at least one property selected from the group consisting of adjusting a surface roughness of the transparent conductive oxide film, adjusting an internal reflectance of the transparent conductive oxide film, adjusting an optical transmission of the transparent conductive oxide film, adjusting a refractive index of the transparent conductive oxide film, adjusting an absorption index of the transparent conductive oxide film, and any combination thereof. The process of nucleation of the deposition material 204 deposited onto the seed layer 103 may include, but is not restricted to a crystallization of deposition material, a nucleation, a heterogeneous nucleation, a homogeneous nucleation, and any combination thereof. Moreover, the seed layer 103 may have an impact on the crystallinity of the transparent conductive oxide film 104. An effect of an improved crystallinity of the transparent conductive oxide film 104 is a higher mobility of free charge carriers in the TCO film resulting in a lower sheet resistance of the TCO film. When applying TCO films in thin film devices, the lower sheet resistance of the TCO films may permit a lower film thickness of the TCO film, which in turn may lead to a reduced optical absorption.

The seed layer 103 may include a material selected from the group consisting of Al, Ti, Zn, Si, and any combination thereof. The seed layer 103 may have a thickness in a range from 1 nm to 10 nm, typically in a range from 5 nm to 10 nm, e.g., approximately 10 nm. According to a typical embodiment which can be combined with other embodiments described herein, the seed layer 103 may essentially be formed from material selected from the group consisting of Al, Ti, Zn, Si, and any combination thereof, i.e. the seed layer may include 90 % by weight or more of any of the materials Al, Ti, Zn, Si, AlOx, TiO, TiOx, SiOx or combinations thereof.

As shown in the side sectional view of Fig. 2, a transparent conductive oxide film 104 may be deposited onto the seed layer 103. Due to the nucleation process described herein above, the transparent conductive oxide film 104 may exhibit a surface texture 106 after etching the surface of the transparent conductive oxide film 104. The transparent conductive oxide film 104 may then act as a front contact. The transparent conductive oxide film 104 above the seed layer 103 may have an etched surface and is adapted for form the front contact.

Prior to depositing the seed layer 103 onto the substrate surface of the substrate 101, the substrate may be washed or roughened. In the typical embodiment shown in Fig. 2, the thin-film layer stack 100 includes the seed layer 103 and the transparent conductive oxide film 104 deposited onto the seed layer 103, the transparent conductive oxide film 104 forming the front contact. The transparent conductive oxide film may include a material selected from the group consisting of doped ZnO, ITO, In₂O₃, SnO₂, CdO, but is typically made of ZnO. It is noted here that ZnO typically is doped with a material such as Al in order to provide defined characteristics such as electrical conductivity.

In accordance with yet a further typical embodiment, which can be combined with other embodiments described herein, the etched surface of the transparent conductive oxide film 104 may have a surface roughness or surface texture which is appropriate e.g. for a good light trapping efficiency. In addition to that, or alternatively, the seed layer 103 may allow a controlled adjustment of surface properties of a subsequent layer and/or a controlled adjustment of interface properties, particularly after etching.

Typically, a doped ZnO layer is deposited by DC-sputtering process as a TCO front contact with a thickness of about 600 - 1000 nm. The dopant can be, but is not restricted to, aluminum. Finally, the layer stack is etched in diluted acid in order to roughen the ZnO surface by wet etching. The TCO layer can be textured resulting in the solar cell precursor. For example, the textured transparent conductive oxide layer can have a layer thickness of 300 nm to 1000 nm, more typically from 400 nm to 900 nm, wherein the thickness of the texture surface is measured with X-ray fluorescence (XRF).

Texture etching is provided in order to achieve a good light-scattering effect. Controlling surface morphology is assisted by applying the seed layer 103 before depositing the transparent conductive oxide film (TCO film). The seed layer 103 provides a first nucleation such that an ongoing film growth of the subsequent deposited TCO film may be effected in order to obtain a desired surface morphology after etching.

Etching may be performed by means of a diluted acid, e.g., by applying wet-etching such that a roughened surface is provided. Prior to depositing any thin film onto the substrate 101, the substrate 101 may be washed such that a clean surface for subsequent deposition is provided. The light-scattering effect is based on an interface shape between the TCO film and an absorber. This effect is related to haze generation within the thin film, e.g. the light scattering effect is visible as haze. Using the deposition method described herein above, according to one typical embodiment which can be combined with other embodiments described herein, a high-rate deposition of large-area substrates 101 can be achieved. Furthermore, the sputtering process provided by the sputter deposition system 200 described herein above with respect to Fig. 1 may be scaled-up to a large extent.

At least one front contact is provided by means of the transparent conductive oxide film 104. If the transparent conductive oxide 104 film has a high surface roughness 106 with large lateral feature sizes, it is possible to couple a large amount of incoming sunlight into an absorber. The absorber may be provided as a Si absorber. The very first nucleation of e.g. zinc oxide (ZnO) provided as a material for the transparent conductive oxide film 104 on the substrate 101 is a key factor for the ongoing film growth and the finally obtained surface morphology after etching. In particular, the composition and structural information of the underlying seed layer, which is deposited prior to the deposition of the zinc oxide, can increase the feature size of the etched ZnO surface. In addition, it is expected that the desired structure can be obtained within a stable process window over the entire substrate area.

In particular, very thin seed layers 103 of less than 10 nm prior to the deposition of the transparent conductive oxide film 104 onto the substrate 101 may increase the feature size of the etched ZnO surface to a large extent. Additionally, the desired structure may be obtained using a stable process window over the entire substrate 101. The process leads to thin-film solar cells having a high solar module current and thus, a high efficiency with respect to standard approach without seed layer. Thus, a higher conductivity and a reduced absorption may be obtained, since the overall film quality is improved. Thus, applications where highly conductive and transparent TCO films are an issue may be based on the sputter deposition process described herein above.

Fig. 3 is a side-sectional view of a layer stack 100 according to another typical embodiment. As shown in Fig. 3, the substrate 101 which may be provided as a glass pane has deposited thereon a buffer layer 102. The buffer layer 102 may have a thickness of below 100 nm, for example, a thickness in a range from 20 nm to 100 nm, typically in a range from 50 nm to 90 nm. According to some embodiments, which can be combined with other embodiments described herein, the buffer layer 102 can be a SiON layer, which is reactively sputtered from a silicon target with addition of oxygen and nitrogen. Moreover, a certain amount of metals such as aluminum, titanium, or zinc can incorporated in the buffer layer 102 by utilizing a mixed-target composition instead of pure silicon.

The buffer layer 102 may be sputtered onto the substrate 101 by means of the reactive sputtering process. Then, a doped ZnO layer acting as the transparent conductive oxide film (TCO film) 104 is deposited onto the seed layer 103. Typically, the transparent conductive oxide film 104 has a thickness in a range from 600 nm to 1000 nm, more typically from 700 nm to 900 nm. The transparent conductive oxide film 104 is deposited by a DC-sputtering process and serves as a TCO front contact. Doping is typically performed by aluminium doping, but the process is not restricted to aluminium doping.

Finally, the layer stack is etched in diluted acid in order to roughen the surface of the transparent conductive oxide film 104 (the ZnO surface, for example) using wet-etching. During the sputter deposition process in the sputter deposition system 200 described herein above with respect to Fig. 1, temperature and pressure have an impact on the surface morphology after etching and, therefore, on the efficiency of the entire solar module.

High deposition rates and easy scalability to large deposition areas may be achieved. Using the DC sputter deposition process, high-haze TCO films may be obtained. The transparent conductive oxide film 104 having the surface texture 106 is deposited onto the seed layer 103, as shown in Fig. 3. The surface texture 106 of the transparent conductive oxide film 104 is a basis for the front contact of the solar cell.

It is noted here, albeit it has been described with respect to Fig. 3, that the buffer layer 102 is deposited directly onto the surface of the substrate 101, the order of the buffer layer 102 and the seed layer 103 may be reversed, i.e., the seed layer 103 may be deposited directly onto the substrate surface 101 as in the layer stack 100 shown in Fig. 2. Then the buffer layer 102 may be deposited onto the seed layer 103. Thus, the seed layer 103 may be located between the buffer layer 102 and the transparent conductive oxide film 104 or the seed layer 103 may be located directly on the bare substrate 101 prior to the deposition of the buffer layer 102.

In other words, the deposition order of the thin films deposited onto the substrate 101 may be provided according to the following two options: (i) depositing buffer layer 102 onto the substrate 101 - depositing the seed layer 103 onto the buffer layer 102 - depositing the transparent conductive oxide film 104 onto the seed layer 103; or (ii) depositing the seed layer 103 directly onto the substrate surface 101 - depositing the buffer layer 102 onto the seed layer 103 - depositing the transparent conductive oxide film onto the buffer layer 102. It is noted here that only option (i) is shown in Fig. 3.

Fig. 4 is a flowchart illustrating a method for controlling surface morphology of a transparent conductive oxide film 104 adapted for use in solar cells. At block 301, the process is started. Then, a substrate 101 is provided (block 302). A seed layer 103 may then be deposited directly onto the substrate surface of the substrate 101, in block 303. A transparent conductive oxide film 104 may be deposited onto the seed layer 304 such that a very first nucleation of the transparent conductive oxide film 104 above the seed layer 103 is influenced.

The seed layer 103 is adapted to control the surface morphology of the transparent conductive oxide film 104. Then, at block 305, the transparent conductive oxide film 104 may be texture-etched. This etching may be provided by a diluted acid, such that wet-etching may be applied. The process is ended at block 306.

In light of the above, a plurality of embodiments have been described. For example, according to one embodiment, a method for controlling surface morphology of a transparent conductive oxide film is provided, the method including providing a substrate; depositing a seed layer above the substrate surface wherein the seed layer includes a material selected from the group consisting of Al, Ti, Zn, Si, and any combination thereof and has a thickness of 10 nm or less; depositing the transparent conductive oxide film above the seed layer, wherein the seed layer is adapted to control the surface morphology of the transparent conductive oxide film; and etching the surface of the transparent conductive oxide film. In accordance with an alternative embodiment, the seed layer is adapted to provide a nucleation of deposition material deposited onto at least portions of the seed layer. Furthermore, the seed layer may be a layer having at least one property selected from the group consisting of adjusting a surface roughness of the transparent conductive oxide film, particularly after etching, adjusting an internal reflectance of the transparent conductive oxide film, adjusting an optical transmission of the transparent conductive oxide film, adjusting a refractive index of the transparent conductive oxide film, adjusting an absorption index of the transparent conductive oxide film, and any combination thereof. According to an optional modification thereof, a process for the nucleation of deposition material deposited onto at least portions of the seed layer may be selected from the group consisting of a crystallization of deposition material, a nucleation, a heterogeneous nucleation, a homogeneous nucleation, and any combination thereof. Moreover, the seed layer may be adapted to adjust optical properties of the transparent conductive film. According to yet further embodiments, which can be combined with any of the other embodiments and modifications above, prior to or after depositing the seed layer, a buffer layer is deposited above the substrate surface or above the seed layer. According to yet further additional or alternative modifications, after depositing the transparent conductive oxide film onto the seed layer, the transparent conductive oxide film is wet-etched by means of an etching acid. Additionally, or alternatively, prior to depositing the seed layer, the substrate surface may be roughened. According to yet further embodiments, which can be combined with any of the other embodiments and modifications above, a layer stack for a thin film solar cell having a front contact is provided, the layer stack including a substrate, a seed layer above the substrate surface adapted for controlling a surface morphology of subsequent layers, wherein the seed layer includes a material selected from the group consisting of Al, Ti, Zn, Si, and any combination thereof and has a thickness of 10 nm or less, and a conductive oxide film above the seed layer, wherein the conductive oxide film has an etched surface, and is adapted to form the front contact. According to an optional modification thereof, the seed layer includes a material selected from the group consisting of Al, Ti, Zn, Si, and any combination thereof. In addition to that the seed layer may have a thickness in a range from 1 nm to 10 nm, typically in a range from 5 nm to 10 nm and, even more typically, has a thickness of approximately 10 nm or less. Furthermore, the transparent conductive oxide film may include a material selected from the group consisting of doped ZnO, ITO, In₂O₃, SnO₂, CdO, and any combination thereof. According to yet further embodiments, which can be combined with any of the other embodiments and modifications above, the conductive oxide film has a thickness in a range from 300 nm to 1000 nm, more typically from 400 nm to 900 nm. Furthermore, the layer stack may include a buffer layer deposited onto the substrate and/or onto the seed layer. According to an optional modification thereof, the buffer layer may have a thickness of below 100 nm, for example, a thickness in a range from 20 nm to 100 nm, typically in a range from 50 nm to 90 nm. Furthermore, the buffer layer may include a material such as SiON, aluminum, titanium, zinc, and any combination thereof. According to yet an alternative embodiment, the transparent substrate includes a glass material and has a washed and/or roughened surface.

While the foregoing is directed to embodiments of the invention, other and further embodiments of the invention may be devised without departing from the basic scope thereof, and the scope thereof is determined by the claims that follow.

## Claims

1. A method for controlling surface morphology of a transparent conductive oxide film, the method comprising:
providing a transparent substrate;
depositing a seed layer above the substrate surface wherein the seed layer comprises a material selected from the group consisting of Al, Ti, Zn, Si, and any combination thereof and has a thickness of 10 nm or less;
depositing the transparent conductive oxide film above the seed layer, wherein the seed layer is adapted to control the surface morphology of the transparent conductive oxide film; and
etching the surface of the transparent conductive oxide film.

2. The method in accordance with claim 1, wherein the seed layer is adapted to provide a nucleation of deposition material deposited onto at least portions of the seed layer.

3. The method in accordance with claim 1 or 2, wherein the seed layer is a layer having at least one property selected from the group consisting of adjusting a surface roughness of the transparent conductive oxide film, particularly after etching, adjusting an internal reflectance of the transparent conductive oxide film, adjusting an optical transmission of the transparent conductive oxide film, adjusting a refractive index of the transparent conductive oxide film, adjusting an absorption index of the transparent conductive oxide film, and any combination thereof.

4. The method in accordance with any one of the preceding claims, wherein a process for the nucleation of deposition material deposited onto at least portions of the seed layer is selected from the group consisting of a crystallization of deposition material, a nucleation, a heterogeneous nucleation, a homogeneous nucleation, and any combination thereof.

5. The method in accordance with any one of the preceding claims, wherein the seed layer is adapted to adjust optical properties of the transparent conductive film.

6. The method in accordance with any one of the preceding claims, wherein, prior to or after depositing the seed layer, a buffer layer is deposited above the substrate surface or above the seed layer.

7. The method in accordance with any one of the preceding claims, wherein, after depositing the transparent conductive oxide film over the seed layer, the transparent conductive oxide film is wet-etched by means of an etching acid.

8. The method in accordance with any one of the preceding claims, wherein, prior to depositing the seed layer, the substrate surface is roughened.

9. A layer stack for a thin film solar cell having a front contact, the layer stack comprising:
a transparent substrate;
a seed layer above the substrate surface adapted for controlling a surface morphology of subsequent layers, wherein the seed layer comprises a material selected from the group consisting of Al, Ti, Zn, Si, and any combination thereof and has a thickness of 10 nm or less; and
a transparent conductive oxide film above the seed layer, wherein the conductive oxide film has an etched surface, and is adapted to form the front contact.

10. The layer stack in accordance with claim 9, wherein the transparent conductive oxide film comprises a material selected from the group consisting of doped ZnO, ITO, In₂O₃, SnO₂, CdO, and any combination thereof.

11. The layer stack in accordance with claim 9 or 10, wherein the conductive oxide film has a thickness typically in a range from 300 nm to 1 µm, and even more typically has a thickness of in a range from 400 to 900 nm.

12. The layer stack in accordance with any one of the claims 9 to 11, wherein the layer stack comprises a buffer layer deposited onto the substrate and/or onto the seed layer.

13. The layer stack in accordance with claim 12, wherein the buffer layer has a thickness of below 100 nm, typically a thickness in a range from 20 nm to 100 nm, and even more typically in a range from 50 nm to 90 nm.

14. The layer stack in accordance with claim 12 or 13, wherein the buffer layer comprises a material selected from the group consisting of SiON, aluminum, titanium, zinc, and any combination thereof.

15. The layer stack in accordance with any one of the claims 9 to 14, wherein the transparent substrate comprises a glass material and has a washed and/or roughened surface.
